(19) **Europäisches Patentamt / European Patent Office / Office européen des brevets**

(11) **EP 4 472 391 A1**

(12) # EUROPEAN PATENT APPLICATION
published in accordance with Art. 153(4) EPC

(43) Date of publication:
04.12.2024 Bulletin 2024/49

(21) Application number: 22924187.2

(22) Date of filing: 22.12.2022

(51) International Patent Classification (IPC):
$H10N\ 10/852$ (2023.01)    $C22C\ 23/00$ (2006.01)
$C22C\ 28/00$ (2006.01)    $H10N\ 10/01$ (2023.01)
$H10N\ 10/853$ (2023.01)

(52) Cooperative Patent Classification (CPC):
C22C 23/00; C22C 28/00; H10N 10/01;
H10N 10/852; H10N 10/853

(86) International application number:
PCT/JP2022/047479

(87) International publication number:
WO 2023/145340 (03.08.2023 Gazette 2023/31)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 28.01.2022 JP 2022012178

(71) Applicant: Panasonic Intellectual Property
Management Co., Ltd.
Kadoma-shi, Osaka 571-0057 (JP)

(72) Inventors:
• ANDO, Fuyuki
Osaka 571-0057 (JP)
• TAMAKI, Hiromasa
Osaka 571-0057 (JP)
• YAMAMURA, Ryosuke
Osaka 571-0057 (JP)

(74) Representative: Eisenführ Speiser
Patentanwälte Rechtsanwälte PartGmbB
Gollierstraße 4
80339 München (DE)

(54) **THERMOELECTRIC CONVERSION MODULE AND THERMOELECTRIC CONVERSION SYSTEM**

(57) A thermoelectric conversion module 1a includes an N-type thermoelectric conversion element 20, a P-type thermoelectric conversion element 10, and an electrode 30. The N-type thermoelectric conversion element 20 includes an N-type thermoelectric conversion material. The P-type thermoelectric conversion element 10 includes a P-type thermoelectric conversion material. The N-type thermoelectric conversion material includes Mg and either Sb or Bi. The P-type thermoelectric conversion material includes Ge, at least one selected from the group consisting of In and Ti, at least one selected from the group consisting of Sb and Bi, and Te. The P-type thermoelectric conversion material satisfies a requirement (1): $\alpha + \beta + \gamma < 1.00$ where $\alpha$ is a molar ratio of a content of Ge to a content of Te, $\beta$ is a molar ratio of a sum of a content of In and a content of Ti to the content of Te, and $\gamma$ is a molar ratio of a sum of a content of Sb and a content of Bi to the content of Te.

FIG.1

# EP 4 472 391 A1

**Description**

TECHNICAL FIELD

The present disclosure relates to a thermoelectric conversion module and a thermoelectric conversion system.

BACKGROUND ART

When a temperature difference occurs between both ends of a thermoelectric conversion material, an electromotive force proportional to the resulting temperature difference is generated. The phenomenon that thermal energy is converted into electrical energy is known as Seebeck effect. Thermoelectric power generation is a technology that uses the Seebeck effect to directly convert thermal energy into electrical energy. In contrast, when an electric current is passed through a thermoelectric conversion material, a heat flow is generated corresponding to the current value, causing a temperature difference between the both ends of the thermoelectric conversion material. This phenomenon is called a Peltier effect. Thermoelectric cooling is a technology that uses the Peltier effect to cool objects by consuming electrical energy.

As known in the field of thermoelectric conversion material, performance of a thermoelectric conversion material used in a thermoelectric conversion device is evaluated by a dimensionless figure of merit ZT. The ZT is an index made dimensionless by multiplying a figure of merit Z by an absolute temperature T. The ZT is expressed as $ZT=S^2\sigma T/\kappa$ using a Seebeck coefficient S of a substance, electric conductivity $\sigma$, and thermal conductivity $\kappa$. When the ZT is higher, the thermoelectric conversion efficiency becomes higher.

Patent Literature 1 describes an n-type thermoelectric conversion material represented by $Mg_{3+m}A_aB_bD_{2-e}E_e$. The element A represents at least one selected from the group consisting of Ca, Sr, Ba, and Yb, and the element B represents at least one selected from the group consisting of Mn and Zn. The element D represents at least one selected from the group consisting of Sb and Bi, and the element E represents at least one selected from the group consisting of Se and Te. This thermoelectric conversion material has a $La_2O_3$-type crystal structure.

Patent Literature 2 describes a thermoelectric conversion element equipped with a thermoelectric conversion layer formed of a thermoelectric conversion material including Mg, at least one selected from the group consisting of Sb and Bi, and at least one selected from the group consisting of Se and Te. This Literature describes further a thermoelectric conversion module equipped with this thermoelectric conversion element and a known p-type thermoelectric conversion element.

Non Patent Literature 1 describes an attempt to improve the thermoelectric performance of a GeTe-based thermoelectric conversion material.

Non Patent Literature 2 describes that in a GeTe-based thermoelectric conversion compound, doping GeTe with Mg and Sb improves the thermoelectric conversion performance.

Non Patent Literature 3 describes an attempt of achieving zT of 2.3 in $Ge_{1-x-y}Sb_xIn_yTe$.

Non Patent Literature 4 describes thermoelectric performance of $Ge_{1-x-y}Ti_xSb_yTe$.

Non Patent Literature 5 describes that $Ge_{0.84}Pb_{0.1}Sb_{0.06}TeB_{0.07}$ has ZT of 2.2 at 773 K.

Non Patent Literature 6 describes that a $Ge_{1-x-y}Cr_xSb_yTe$ alloy can exhibit ZT of more than 2.2.

Non Patent Literature 7 describes a general formula for the efficiency of thermoelectric power generation.

Non Patent Literature 8 describes an electrical resistivity, a Seebeck coefficient, a power factor, and a figure of merit of $Mg_{3.2}Sb_{1.5}Bi_{0.49}Te_{0.01}$.

Non Patent Literature 9 describes a conversion efficiency of a thermoelectric generation module using n-type $Pb_{0.93}Sb_{0.05}S_{0.5}Se_{0.5}$ and p-type Na-doped PbTe.

2

CITATION LIST

Patent Literature

Patent Literature 1: JP 6127281 B2
Patent Literature 2: WO 2020/003554 A1

Non Patent Literature

Non Patent Literature 1: W. Liu, et al., "High-Performance GeTe-Based Thermoelectrics: from Materials to Devices", Adv. Energy Mater. 20, 2000367 (2020)
Non Patent Literature 2: T. Xing, et al., "Superior performance and high service stability for GeTe-based thermoelectric compounds", Natl. Sci. Rev. 6, 944-954 (2019)
Non Patent Literature 3: M. Hong et al., "Realizing zT of 2.3 in Ge1-x-ySbxInyTe via Reducing the Phase-Transition Temperature and Introducing Resonant Energy Doping", Advanced Materials, Vol. 30, Issue 1705942 (2018)
Non Patent Literature 4: M. Li et al., "Crystal symmetry induced structure and bonding manipulation boosting thermoelectric performance of GeTe", Nano Energy, Vol. 73, Issue 104740 (2020)
Non Patent Literature 5: G. Bai et al., "Boron Strengthened GeTe-Based Alloys for Robust Thermoelectric Devices with High Output Power Density", Adv. Energy Mater. 11, 2102012 (2021)
Non Patent Literature 6: M. Hong et al., "Computer-aided design of high-efficiency GeTe-based thermoelectric devices", Energy Environ. Sci. 13, 1856-1864
(2020) Non Patent Literature 7: G. J. Snyder, "Thermoelectric Power Generation: Efficiency and Compatibility", in Thermoelectrics Handbook: Macro to Nano, ed. D. M. Rowe, CRC Press, ch. 9 (2006)
Non Patent Literature 8: T. Kanno et al., "Enhancement of average thermoelectric figure of merit by increasing the grain-size of Mg3.2Sb1.5Bi0.49Te0.01", Energy Environ. Sci., 13, 579-591(2020)
Non Patent Literature 9: B. Jiang et al., "Realizing high-efficiency power generation in low-cost PbS-based thermoelectric materials", Energy Environ. Sci., 13, 579-591(2020)

SUMMARY OF INVENTION

Technical Problem

The present disclosure provides a novel thermoelectric conversion module that is advantageous from a viewpoint of practical utility.

Solution to Problem

A thermoelectric conversion module of the present disclosure includes:

an N-type thermoelectric conversion element;
a P-type thermoelectric conversion element; and
an electrode electrically connecting the P-type thermoelectric conversion element and the N-type thermoelectric conversion element,
wherein the N-type thermoelectric conversion element includes an N-type thermoelectric conversion material,
the P-type thermoelectric conversion element includes a P-type thermoelectric conversion material,
the N-type thermoelectric conversion material includes Mg, and at least one selected from the group consisting of Sb and Bi,
the P-type thermoelectric conversion material includes Ge, at least one selected from the group consisting of In and Ti, at least one selected from the group consisting of Sb and Bi, and Te,
the P-type thermoelectric conversion material satisfies a requirement (1): $\alpha + \beta + \gamma < 1.00$,

where $\alpha$ is a molar ratio of a content of Ge to a content of Te,

$\beta$ is a molar ratio of a sum of a content of In and a content of Ti to the content of Te, and

γ is a molar ratio of a sum of a content of Sb and a content of Bi to the content of Te.

Advantageous Effects of Invention

The present disclosure provides a novel thermoelectric conversion module that is advantageous from a viewpoint of practical utility.

BRIEF DESCRIPTION OF DRAWINGS

FIG. 1 is a perspective view showing an example of a thermoelectric conversion module of the present disclosure.
FIG. 2A is a schematic diagram showing an example of a thermoelectric conversion module of the present disclosure.
FIG. 2B is a schematic diagram showing another example of a thermoelectric conversion module of the present disclosure.
FIG. 2C is a schematic diagram showing still another example of a thermoelectric conversion module of the present disclosure.
FIG. 2D is a schematic diagram showing still another example of the thermoelectric conversion module of the present disclosure.
FIG. 2E is a schematic diagram showing an example of a thermoelectric conversion system of the present disclosure.
FIG. 3A is a diagram showing a NaCl-type crystal structure.
FIG. 3B is a diagram showing a $La_2O_3$-type crystal structure.
FIG. 4A is a graph showing X-ray diffraction measurement results of thermoelectric conversion materials according to Samples 1 to 3.
FIG. 4B is a graph showing a result of X-ray diffraction measurement of thermoelectric conversion material according to Sample 8.
FIG. 5 is a graph showing a relationship between temperature and a thermal expansion coefficient of a thermoelectric conversion material.
FIG. 6A is a diagram schematically showing a three-point bending test.
FIG. 6B is a graph showing a breaking stress of a thermoelectric conversion material according to each Sample, determined from a result of three-point bending test.
FIG. 7A is a graph showing a relationship between temperature and a dimensionless figure of merit ZT of a thermoelectric conversion material according to each of Samples 1 to 3.
FIG. 7B is a graph showing a relationship between temperature and a dimensionless figure of merit ZT of a thermoelectric conversion material according to Sample 8.
FIG. 8 is a graph showing an example of a predicted result of a thermoelectric conversion efficiency of a thermoelectric conversion module of the present disclosure.

DESCRIPTION OF EMBODIMENTS

(Findings on which the present disclosure is based)

A thermoelectric conversion module having a π-type structure is known as a component of a thermoelectric conversion device. In this thermoelectric conversion module, a P-type thermoelectric conversion element and an N-type thermoelectric conversion element having Seebeck coefficients of signs different from each other are arranged in series electrically and in parallel with regard to a heat flow. This allows an efficient thermoelectric conversion. For thermoelectric conversion modules with a practical π-type structure, durability against a stress caused by applied pressure or a thermal stress caused by temperature differences is important. Therefore, it is important that the P-type thermoelectric conversion material and the N-type thermoelectric conversion material have sufficient mechanical strength. In addition, it is important that the difference in thermal expansion coefficient between the P-type thermoelectric conversion material and the N-type thermoelectric conversion material is small, and that the generation of local thermal stress itself is prevented/reduced.
According to studies by the present inventors, an N-type thermoelectric conversion material including Mg and at least one selected from the group consisting of Sb and Bi can exhibit a ZT of more than 1.5. On the other hand, a P-type thermoelectric conversion material that has a thermal expansion coefficient close to that of the N-type thermoelectric conversion material and that can exhibit a high ZT in the operating temperature range of the N-type thermoelectric conversion material has not yet been found. For this reason, it has been difficult to generate electricity with high power generation efficiency in a thermoelectric conversion module using such an N-type thermoelectric conversion material. For example, a P-type $Mg_3Sb_2$-based compound is compatible with an N-type $Mg_3Sb_2$-based compound from the viewpoint of thermal expansion coefficient and operating temperature range, but its ZT is about 0.5 at most. MgAgSb-based compounds are promising from the viewpoint of thermal expansion compatibility and the ZT level. However, since a MgAgSb-based compound exhibits a structural phase transition with rapid structural changes at around 300°C, it is difficult to use the compound at a high temperature that exceeds 300°C.

As for the P-type GeTe-based compound, as described in Non Patent Literature 1, substitution of its Ge site by Sb or any other element allows this compound to exhibit ZT exceeding 1.5 and reaching 2.0. In the meantime, a problem for a GeTe-based compound is that the linearity of the thermal expansion coefficient tends to collapse at a high temperature since the compound undergoes a phase transition from a rhombohedral phase to a cubic phase at around 300°C. According to Non Patent Literature 2, by doping GeTe with Mg and Sb, the temperature change in the thermal expansion coefficient becomes linear, and the properties of an 8 mm long element are maintained in a cycle test in which the temperature raising step and temperature lowering step are repeated. In addition, it has been disclosed that the thermal expansion coefficient $dL/L_0$ increases to approximately $8 \times 10^{-3}$ [K$^{-1}$] when the temperature rises from 30°C to 430°C. In other words, it can be comparable to the typical thermal expansion coefficient of an N-type $Mg_3Sb_2$-based compound. Therefore, it is conceivable to configure a thermoelectric conversion module by combining an N-type $Mg_3Sb_2$-based compound and a P-type GeTe-based compound doped with Mg and Sb.

On the other hand, according to studies by the present inventors, $Ge_{0.85}Mg_{0.05}Sb_{0.1}Te$ disclosed in Non Patent Literature 2 is easily broken during cutting and is difficult to process. In addition, this material has low mechanical strength and is brittle, resulting in poor impact resistance, and thus, cracks are likely to occur in the thermoelectric conversion material due to the forces applied to the thermoelectric conversion module during use of the thermoelectric conversion module. As a result, it was discovered that the thermoelectric conversion module is prone to failure. By adjusting x in the composition of $Ge_xMg_ySb_zTe$ to less than 0.83, the breaking stress of the compound is likely to increase. However, compared to $Ge_{0.85}Mg_{0.05}Sb_{0.1}Te$, the output factor $S^2\sigma$ is difficult to increase.

In view of these circumstances, the present inventors have conducted extensive studies on a P-type thermoelectric conversion material that can configure a novel thermoelectric conversion module advantageous from the viewpoint of practice utility, when combined with an N-type thermoelectric conversion material including Mg and at least one selected from the group consisting of Sb and Bi. And the present inventors have found that a certain material including Ge, at least one selected from the group consisting of In and Ti, at least one selected from the group consisting of Sb and Bi, and Te, has desired properties from the viewpoint of practical utility. Based on this new knowledge, the present inventors have completed the thermoelectric conversion material according to the present disclosure.

(Embodiment of the present disclosure)

Embodiments of the present disclosure will be described below with reference to the attached drawings.

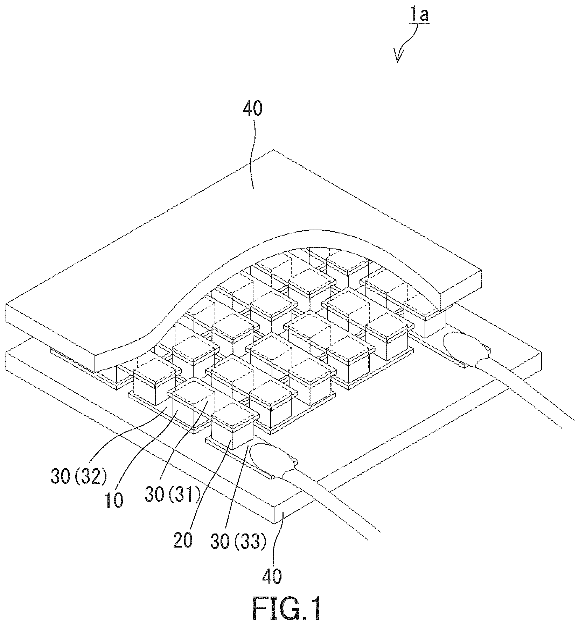

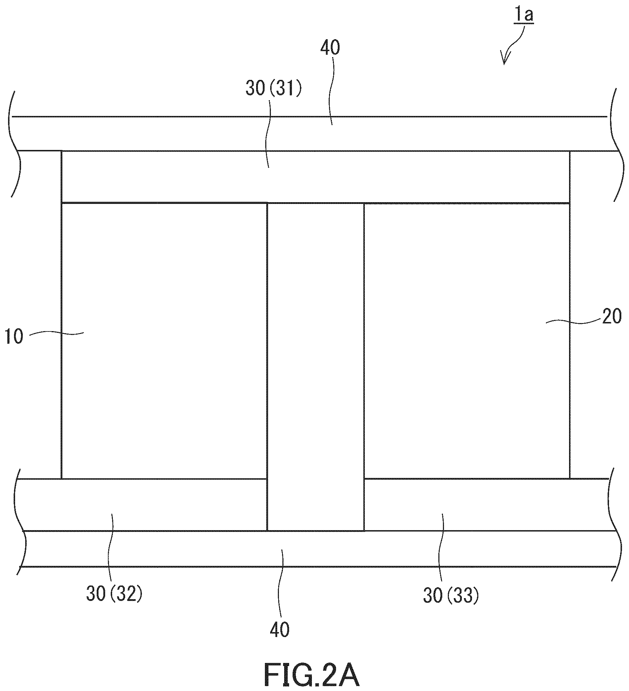

FIG. 1 is a perspective view showing an example of a thermoelectric conversion module of the present disclosure. FIG. 2A is a schematic diagram showing an example of the thermoelectric conversion module of the present disclosure.

As shown in FIGs. 1 and 2A, a thermoelectric conversion module 1a includes N-type thermoelectric conversion elements 20, P-type thermoelectric conversion elements 10, and electrodes 30. The N-type thermoelectric conversion elements 20 include an N-type thermoelectric conversion material. The N-type thermoelectric conversion material includes Mg and at least one selected from the group consisting of Sb and Bi. The electrodes 30 electrically connect the P-type thermoelectric conversion elements 10 and the N-type thermoelectric conversion elements 20.

The P-type thermoelectric conversion elements 10 include a P-type thermoelectric conversion material. The P-type thermoelectric conversion material includes Ge, at least one selected from the group consisting of In and Ti, at least one selected from the group consisting of Sb and Bi, and Te. The P-type thermoelectric conversion material satisfies a requirement (1): $\alpha + \beta + \gamma < 1.00$. In the requirement (1), $\alpha$ is a molar ratio of a content of Ge to a content of Te. $\beta$ is a molar ratio of a sum of a content of In and a content of Ti to the content of Te. $\gamma$ is a molar ratio of a sum of a content of Sb and a content of Bi to the content of Te. The contents of Ge, In, Ti, Sb, Bi, and Te in the thermoelectric conversion material can be determined, for example, in accordance with SEM-EDX that is a combination of scanning electron microscopy (SEM) and energy dispersive-type X-ray spectroscopy (EDX).

When the P-type thermoelectric conversion material satisfies the requirement (1), it will make it easier to sufficiently decrease the difference between the thermal expansion coefficient of the P-type thermoelectric conversion element 10 and the thermal expansion coefficient of the N-type thermoelectric conversion element 20 including the N-type thermoelectric conversion material in the temperature range from 30°C to 400°C. In addition, the P-type thermoelectric conversion materials is more likely to have a desired breaking stress. Furthermore, the P-type thermoelectric conversion material is more likely to exhibit desired thermoelectric conversion performance. Therefore, the thermoelectric conversion module 1a is advantageous from a viewpoint of practical utility.

The P-type thermoelectric conversion material may satisfy a requirement $\alpha + \beta + \gamma \leq 0.99$, may satisfy a requirement $\alpha + \beta + \gamma \leq 0.98$, or may satisfy a requirement $\alpha + \beta + \gamma \leq 0.97$.

The P-type thermoelectric conversion material, for example, satisfies a requirement (3): $\beta + \gamma < \alpha$. Thereby, the P-

type thermoelectric conversion material is more likely to have desired properties from the viewpoint of thermal expansion coefficient, breaking stress, and thermoelectric conversion performance.

In the P-type thermoelectric conversion material, $\alpha$ - ($\beta$ + $\gamma$) is not limited to a specific value. The P-type thermoelectric conversion material, for example, satisfies a requirement $0.45 \leq \alpha$ - ($\beta$ + $\gamma$) < 1. In this case, the P-type thermoelectric conversion material is more likely to have desired properties from the viewpoint of thermal expansion coefficient, breaking stress, and thermoelectric conversion performance.

The P-type thermoelectric conversion material, for example, satisfies a requirement (4): $\alpha + \beta + \gamma \geq 0.85$. Thereby, the P-type thermoelectric conversion material is more likely to have desired properties from the viewpoint of thermal expansion coefficient, breaking stress, and thermoelectric conversion performance.

The P-type thermoelectric conversion material may satisfy a requirement $\alpha + \beta + \gamma \geq 0.86$, may satisfy a requirement $\alpha + \beta + \gamma \geq 0.87$, may satisfy a requirement $\alpha + \beta + \gamma \geq 0.88$, or may satisfy a requirement $\alpha + \beta + \gamma \geq 0.89$.

The P-type thermoelectric conversion material may satisfy a requirement $0.85 \leq \alpha + \beta + \gamma \leq 0.99$, may satisfy a requirement $0.86 \leq \alpha + \beta + \gamma \leq 0.99$, or may satisfy a requirement $0.87 \leq \alpha + \beta + \gamma \leq 0.99$. The upper limit of $\alpha + \beta + \gamma$ may be 0.99, may be 0.98, or may be 0.97. The lower limit of $\alpha + \beta + \gamma$ may be 0.85, may be 0.86, may be 0.87, may be 0.88, or may be 0.89. The range of $\alpha + \beta + \gamma$ can be defined by any combination of the upper and lower limits.

The P-type thermoelectric conversion material, for example, has a first constitution represented by $Ge_\alpha In_x Ti_{\beta-x} Sb_y Bi_{\gamma-y} Te$. In this first constitution, requirements $0 \leq x \leq \beta$ and $0 \leq y \leq \gamma$ are satisfied. In this case, the P-type thermoelectric conversion material is more likely to have desired properties from the viewpoint of thermal expansion coefficient, breaking stress, and thermoelectric conversion performance.

In the first constitution, a requirement $\alpha \geq 0.75$ may be satisfied, a requirement $\alpha \geq 0.77$ may be satisfied, a requirement $\alpha \geq 0.78$ may be satisfied, a requirement $\alpha \geq 0.80$ may be satisfied, or a requirement $\alpha \geq 0.82$ may be satisfied. In the first constitution, a requirement $\alpha \leq 0.99$ may be satisfied, a requirement $\alpha \leq 0.98$ may be satisfied, or a requirement $\alpha \leq 0.96$ may be satisfied. In the first constitution, a requirement $\alpha \leq 0.94$ may be satisfied, a requirement $\alpha \leq 0.92$ may be satisfied, or a requirement $\alpha \leq 0.90$ may be satisfied.

In the first constitution, a requirement $\beta \geq 0.001$ may be satisfied, a requirement $\beta \geq 0.002$ may be satisfied, a requirement $\beta \geq 0.003$ may be satisfied, a requirement $\beta \geq 0.004$ may be satisfied, or a requirement $\beta \geq 0.005$ may be satisfied. In the first constitution, a requirement $\beta \leq 0.09$ may be satisfied, a requirement $\beta \leq 0.08$ may be satisfied, a requirement $\beta \leq 0.07$ may be satisfied, a requirement $\beta \leq 0.06$ may be satisfied, or a requirement $\beta \leq 0.05$ may be satisfied. The first constitution, for example, satisfies a requirement $0.001 \leq \beta \leq 0.04$. Thereby, the P-type thermoelectric conversion material is more likely to have desired properties from the viewpoint of thermal expansion coefficient, breaking stress, and thermoelectric conversion performance.

In the first constitution, a requirement $\gamma \geq 0.01$ may be satisfied, a requirement $\gamma \geq 0.02$ may be satisfied, a requirement $\gamma \geq 0.03$ may be satisfied, or a requirement $\gamma \geq 0.04$ may be satisfied. In the first constitution, a requirement $\gamma \leq 0.19$ may be satisfied, a requirement $\gamma \leq 0.18$ may be satisfied, a requirement $\gamma \leq 0.17$ may be satisfied, a requirement $\gamma \leq 0.16$ may be satisfied, or a requirement $\gamma \leq 0.15$ may be satisfied. The first constitution, for example, satisfies a requirement $0.04 \leq \gamma \leq 0.15$. Thereby, the P-type thermoelectric conversion material is more likely to have desired properties from the viewpoint of thermal expansion coefficient, breaking stress, and thermoelectric conversion performance.

The crystal structure of the P-type thermoelectric conversion material is not limited to any particular crystal structure. The P-type thermoelectric conversion material, for example, has a NaCl-type crystal structure. In this case, the P-type thermoelectric conversion material is more likely to have desired properties from the viewpoint of thermal expansion coefficient, breaking stress, and thermoelectric conversion performance. The P-type thermoelectric conversion material may have a crystal structure belonging to at least one of a space group Fm-3m and a space group R-3m. Similarly in this case, the P-type thermoelectric conversion material is more likely to have desired properties from the viewpoint of thermal expansion coefficient, breaking stress, and thermoelectric conversion performance.

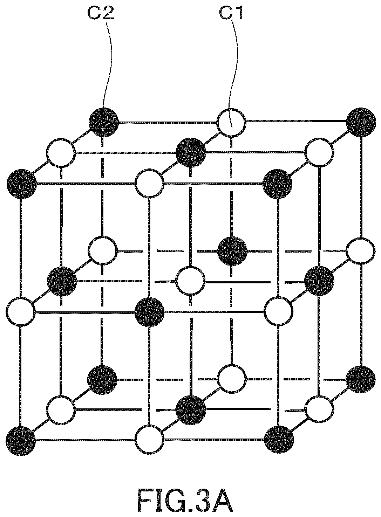

FIG. 3A schematically shows a NaCl-type crystal structure. In FIG. 3A, C1 indicates a Na site, and C2 indicates a Cl site. In a case where the P-type thermoelectric conversion material has a NaCl-type crystal structure, Ge, Ti, Sb, and Bi may be arranged at a Na site, and Te may be arranged at a Cl site. Thereby, the P-type thermoelectric conversion material is more likely to exhibit desired thermoelectric conversion performance and more likely to have a desired strength. It should be noted that in the P-type thermoelectric conversion material, not all sites in the crystal structure need to be filled, and lattice defects such as vacancies may be present in the crystal structure.

The P-type thermoelectric conversion material is, for example, a polycrystal including a plurality of crystal grains. Each of the crystal grains has, for example, a NaCl-type crystal structure. Thereby, the P-type thermoelectric conversion material is more likely to have desired properties from the viewpoint of thermal expansion coefficient, breaking stress, and thermoelectric conversion performance. For example, the crystal structure of the crystal grains can be confirmed by analyzing the thermoelectric conversion material in accordance with the X-ray diffraction method.

The P-type thermoelectric conversion material has a breaking stress BS that is not limited to any particular value. In the thermoelectric conversion material, for example, a requirement $40 \text{ N/mm}^2 \leq BS \leq 5000 \text{ N/mm}^2$ is satisfied. In the requirement, BS indicates the breaking stress BS of the P-type thermoelectric conversion material. The breaking stress BS of the P-type thermoelectric conversion material can be determined, for example, by a three-point bending test. The three-point bending test is performed using a test piece that is prepared from a P-type thermoelectric conversion material for the three-point bending test. The breaking stress of the P-type thermoelectric conversion material can be determined by dividing the breaking load of the test piece in this test by the area of the fracture surface of the test piece. The shape and dimensions of the test piece can be determined from the viewpoint of the area of the fracture surface, the distance between fulcrums, and easiness in calculation of the point of effort. The test piece is rectangular parallelepiped, for example. The three-point bending test is preferably performed with two or more test pieces for each P-type thermoelectric conversion material. The three-point bending test, more desirably, is performed with four or more test pieces. The three-point bending test is performed at 25°C, for example. For example, a three-point bending test can be performed by a testing machine conforming to Japanese Industrial Standard JIS B7721 Class 1, ISO 7500-1 Class 1, EN10002-2 Grade 1, or ASTM E4.

A P-type thermoelectric conversion material with a breaking stress BS satisfying the aforementioned requirement has high toughness, and for instance, a sintered body including the P-type thermoelectric conversion material can be cut easily. The P-type thermoelectric conversion material desirably satisfies a requirement $BS \geq 45$ N/mm$^2$. It may satisfy a requirement $BS \geq 50$ N/mm$^2$, may satisfy a requirement $BS \geq 55$ N/mm$^2$, or may satisfy a requirement $BS \geq 60$ N/mm$^2$. The thermoelectric conversion material may satisfy a requirement $BS \leq 4000$ N/mm$^2$, may satisfy a requirement $BS \leq 3000$ N/mm$^2$, may satisfy a requirement $BS \leq 2000$ N/mm$^2$, or may satisfy a requirement $BS \leq 1000$ N/mm$^2$. The thermoelectric conversion material may satisfy a requirement $BS \leq 500$ N/mm$^2$.

The N-type thermoelectric conversion material, for example, includes a $Mg_3(Sb,Bi)_2$-based N-type thermoelectric conversion material. In this Description, (Sb, Bi) indicates that at least one selected from the group consisting of Sb and Bi is included. The $Mg_3(Sb,Bi)_2$-based N-type thermoelectric conversion material includes $Mg_3(Sb,Bi)_2$ and a material where an element of a part of $Mg_3(Sb,Bi)_2$ is substituted by another element. In a case where the $Mg_3(Sb,Bi)_2$-based N-type thermoelectric conversion material is a material where an element of a part of $Mg_3(Sb,Bi)_2$ is substituted by another element, the content of the other element is smaller than the content of Mg on the basis of a molar ratio, for example. Further, the content of the other element is less than the sum of the content of Sb and the content of Bi on the basis of a molar ratio. Examples of the other element to substitute the element of a part of $Mg_3(Sb,Bi)_2$ include Ca, Sr, Ba, Nb, Zn, Al, Sc, Y, La, Ce, Mn, Si, Cr, Se, and Te.

The constitution of the N-type thermoelectric conversion material is not limited to any particular constitution. The N-type thermoelectric conversion material, for example, has a second constitution represented by $Mg_{3+m-a-b}A_aB_bC_{2-c-e}D_cE_e$. In the second constitution, A is at least one element selected from the group consisting of Ca, Sr, Ba, Nb, Zn, and Al. B is at least one element selected from the group consisting of Sc, Y, La, and Ce. C is at least one element selected from the group consisting of Sb and Bi. D is at least one element selected from the group consisting of Mn, Si, and Cr. E is at least one element selected from the group consisting of Se and Te. In the second constitution, for example, requirements $-0.1 \leq m \leq 0.4$, $0 \leq a \leq 0.1$, $0 \leq b \leq 0.04$, $0 \leq c \leq 0.1$, and $0.001 \leq e \leq 0.06$ are satisfied. Thereby, a thermoelectric conversion module 1a is likely exhibit a desired generation efficiency.

The crystal structure of the N-type thermoelectric conversion material is not limited to any particular crystal structure. The N-type thermoelectric conversion material, for example, has a $La_2O_3$-type crystal structure.

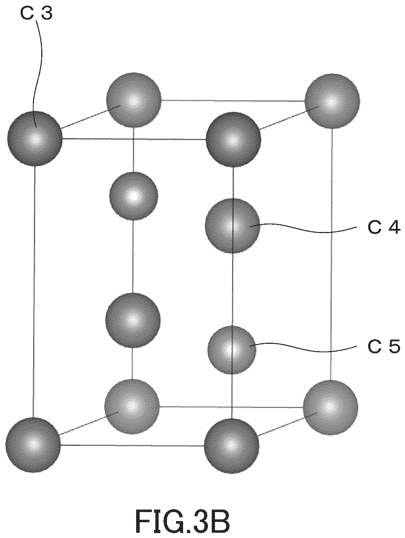

FIG. 3B schematically shows a $La_2O_3$-type crystal structure of an N-type thermoelectric conversion material. In this crystal structure, a part of Mg site C3 may be substituted by an element corresponding to A or B. This crystal structure has a site C4 formed of Mg. This crystal structure has a site C5 formed of at least one kind of element selected from the group consisting of Sb and Bi.

In the thermoelectric conversion module 1a, the thermal expansion coefficient of the N-type thermoelectric conversion material and the thermal expansion coefficient of the P-type thermoelectric conversion material are not limited to any particular relationship. In the thermoelectric conversion module 1a, the N-type thermoelectric conversion material and the P-type thermoelectric conversion material, for example, satisfy a requirement (2): $|(Xn - Xp)/Xn| \leq 0.3$. Here, Xn indicates the thermal expansion coefficient of the N-type thermoelectric conversion material at a specific temperature in the temperature range from 30°C to 400°C. Xp is the thermal expansion coefficient of P-type thermoelectric conversion material at a specific temperature in the temperature range from 30°C to 400°C. The thermal expansion coefficient of the P-type thermoelectric conversion material at 400°C is, for example, $6.5 \times 10^{-3}$ [K$^{-1}$] or more and $7.3 \times 10^{-3}$ [K$^{-1}$] or less. In this case, in the thermoelectric conversion module 1a, the difference between the thermal expansion coefficient of the N-type thermoelectric conversion material and the thermal expansion coefficient of the P-type thermoelectric conversion material is small, and thus, cracks in the thermoelectric conversion material, which is caused by the thermal stress in the thermoelectric conversion module 1a, is likely to be prevented or reduced. Therefore, the thermoelectric conversion module 1a is likely to have a high reliability. The thermal expansion coefficient of the N-type thermoelectric conversion material and the thermal expansion coefficient of the P-type thermoelectric conversion material can be determined, for example, by a thermomechanical analysis (TMA). As an example of the thermomechanical analysis for determining the thermal expansion coefficient, the method described in Examples can be referred to.

In the thermoelectric conversion module 1a, a requirement $|(Xn - Xp)/Xn| \leq 0.25$ may be satisfied, or a requirement $|(Xn - Xp)/Xn| \leq 0.20$ may be satisfied.

As shown in FIGs. 1 and 2A, the thermoelectric conversion module 1a has, for example, a π-type structure. In the thermoelectric conversion module 1a, for example, a plurality of P-type thermoelectric conversion elements 10 and a plurality of N-type thermoelectric conversion elements are electrically connected in series by electrodes 30. As shown in FIGs. 1 and 2A, the electrodes 30 include, for example, a first electrode 31, a second electrode 32, and a third electrode 33. One end of a P-type thermoelectric conversion element 10 and one end of an N-type thermoelectric conversion element 20 are connected electrically to each other by the first electrode 31. The other end of the P-type thermoelectric conversion element 10 is electrically connected to the second electrode 32. The other end of the N-type thermoelectric conversion element 20 is electrically connected to the third electrode 33.

The material of the electrodes 30 is not limited to a particular material as long as the electrodes 30 are capable of electrically connecting the P-type thermoelectric conversion element 10 and the N-type thermoelectric conversion element 20. The electrodes 30 may include, for example, at least one selected from the group consisting of, silver, copper, and gold.

As shown in FIGs. 1 and 2A, the thermoelectric conversion module 1a, for example, includes a pair of substrates 40. The P-type thermoelectric conversion element 10, the N-type thermoelectric conversion element 20, and the electrodes 30 are disposed between the pair of substrates 40. One of the substrates 40 is disposed in contact with the first electrode 31, and the other substrate 40 is disposed in contact with the second electrode 32 and the third electrode 33. In such a configuration, temperature variations are less likely to occur in the direction parallel to the main surfaces of the substrates 40 in the thermoelectric conversion module 1a. The material of the substrates 40 is not limited to a particular material. The substrates 40 include, for example, alumina or aluminum nitride.

In the thermoelectric conversion module 1a, for example, each of the P-type thermoelectric conversion elements 10 and each of the N-type thermoelectric conversion elements 20 are joined to the substrates 40 by predetermined joining layers that compose the electrodes 30. The joining layers are formed of, for example, a silver-containing paste, a silver-containing brazing material, a copper-containing paste, or a copper-containing brazing material. The joining layers may be formed of a solder material with a high melting point, such as a Pb alloy and an Au alloy.

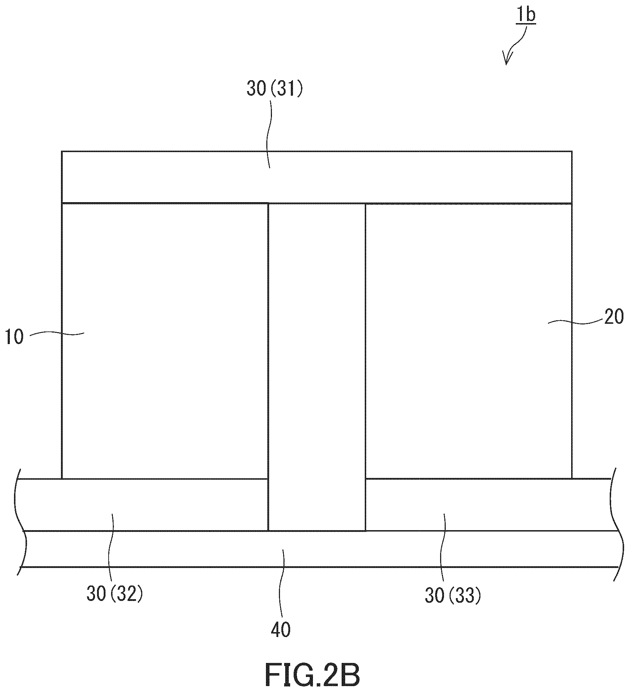

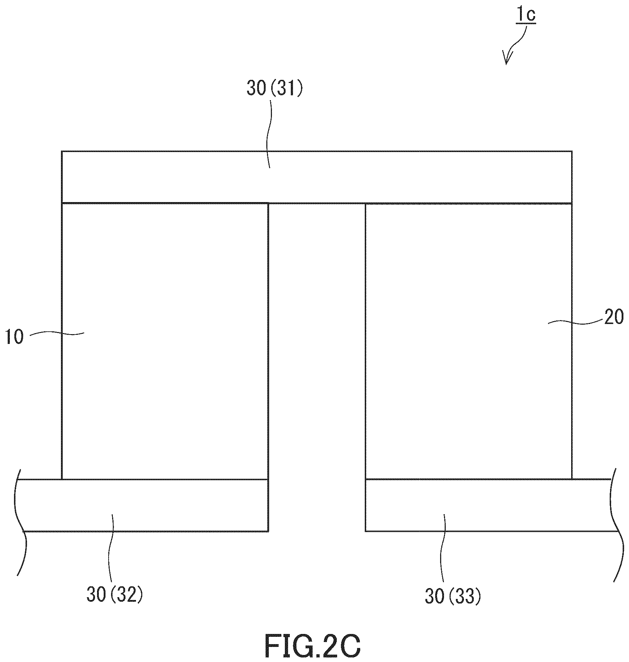

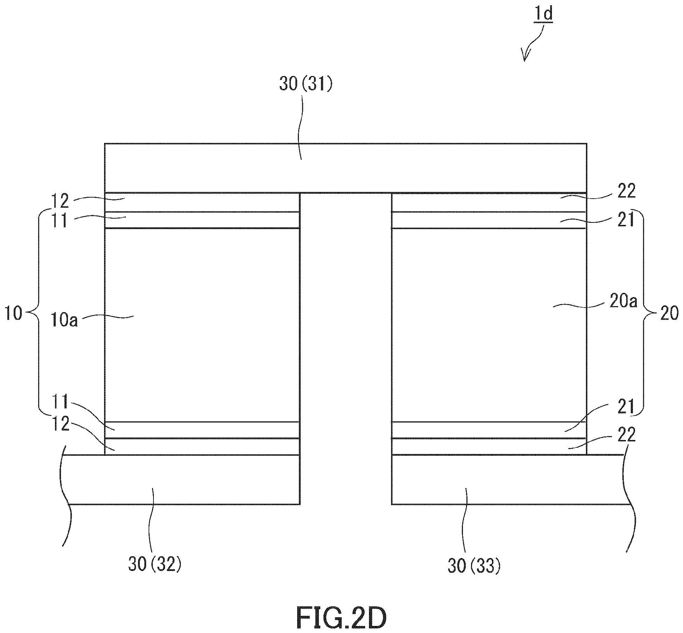

FIG. 2B, FIG. 2C, and FIG. 2D are schematic diagrams showing other examples of a thermoelectric conversion module of the present disclosure. Each of the thermoelectric conversion modules 1b, 1c, and 1d illustrated in FIG. 2B, FIG. 2C, and FIG. 2D is configured in the same manner as the thermoelectric conversion module 1a except for parts that are specifically explained. Components of the thermoelectric conversion modules 1b, 1c, and 1d that are the same as or correspond to the components of the thermoelectric conversion module 1a are given the same reference numerals, and detailed explanations therefor are omitted. The description regarding the thermoelectric conversion module 1a also applies to the thermoelectric conversion modules 1b, 1c, and 1d unless technically contradictory.

As shown in FIG. 2B, the thermoelectric conversion module 1b includes a substrate 40. The substrate 40 is disposed to be in contact with the second electrode 32 and the third electrode 33. In the meantime, the thermoelectric conversion module 1b has no substrate 40 disposed in the vicinity of the first electrode 31, namely, the thermoelectric conversion module 1b has a half-skeleton structure.

As shown in FIG. 2C, a thermoelectric conversion module 1c has no substrate 40, and the electrode 30 is exposed. That is, the thermoelectric conversion module 1c has a full-skeleton structure.

As shown in FIG. 2D, in the thermoelectric conversion module 1d, the P-type thermoelectric conversion element 10 has a P-type thermoelectric conversion body 10a including a P-type thermoelectric conversion material, and first layers 11. Each of the first layers 11 is disposed between the P-type thermoelectric conversion body 10a and the electrode 30. The first layers 11 include at least one metal selected from the group consisting of Fe, Cu, Ti, Mo, W, and Ni, an alloy containing Sn and Te, or an alloy containing Al and Si. This configuration makes it easier to prevent or reduce degradation in the thermoelectric conversion performance of the P-type thermoelectric conversion element 10, where the degradation is caused by a diffusion of substances between the P-type thermoelectric conversion element 10 and the electrodes 30. For example, the first layers 11 are formed at both end portions of the P-type thermoelectric conversion element 10, and joining layers 12 are formed between the first layers 11 and the electrodes 30. The joining layers 12 may be configured similarly to the joining layer of the thermoelectric conversion module 1a.

As shown in FIG. 2D, in the thermoelectric conversion module 1d, the N-type thermoelectric conversion element 20 has an N-type thermoelectric conversion body 20a including an N-type thermoelectric conversion material, and second layers 21. Each of the second layer 21 is disposed between the N-type thermoelectric conversion body 20a and an electrode 30. The second layers 21 include Cu or Fe. This configuration makes it easier to prevent or reduce degradation in the thermoelectric conversion performance of the N-type thermoelectric conversion element 20, where the degradation is caused by a diffusion of substances between the N-type thermoelectric conversion element 20 and the electrodes 30. For example, the second layers 21 are formed at both end portions of the N-type thermoelectric conversion element 20, and joining layers 22 are formed between the second layer 21 and the electrodes 30. The joining layers 22 may be configured similarly to the joining layer of the thermoelectric conversion module 1a.

The second layer 21 may include a simple substance of Cu, or may include a Cu alloy containing a component such as Zn, Mg, or Ca. The second layers 21 may include a simple substance of Fe or may include a Fe alloy such as stainless steel.

An example of a method of manufacturing the thermoelectric conversion module of the present disclosure will be explained. A raw material of the P-type thermoelectric conversion material is melted at a temperature of 700°C or higher, thereby obtaining a melt. The melt is then quenched, thereby obtaining a first ingot. The raw material for the P-type thermoelectric conversion material is, for example, a simple substance. The first ingot is pulverized to produce a first powder, and the obtained first powder is sintered by a method such as hot pressing or spark plasma sintering (SPS). In this way, a high-density second ingot can be obtained. The first layer 11 is formed by sintering, if necessary, the raw material powder for the first layer 11 together with the first powder. Alternatively, the first layer 11 may be formed by any method such as integral sintering, plating, or thermal spraying, after cutting the second ingot into a predetermined shape.

A second powder is produced from a raw material for the N-type thermoelectric conversion material by a method such as mechanical alloying, melting, or a solid phase reaction. The second powder is sintered by a method such as hot pressing or SPS to produce a high-density third ingot. The second layer 21 is formed by sintering, if necessary, the raw material powder for the second layer 21 together with the second powder. The second layer 21 may be formed by any method such as integral sintering, plating, or thermal spraying, after cutting the third ingot into a predetermined shape.

The second ingot including the P-type thermoelectric conversion material and the third ingot including the N-type thermoelectric conversion material are, for example, flat plates. Each flat ingot is diced into a square or rectangular shape in a planar view, whereby the P-type thermoelectric conversion element 10 and the N-type thermoelectric conversion element 20 are obtained. On the substrate 40 or on a predetermined surface, the P-type thermoelectric conversion element 10 and the N-type thermoelectric conversion element 20 each is arranged in contact with the electrode 30. The P-type thermoelectric conversion element 10 and the N-type thermoelectric conversion element 20 each is joined to the electrode 30 via a binder. The binder may be a brazing medium, a solder compound, or a sinterable metal-containing paste. Heating the binder causes melting of the binder or sintering of the component in the binder, thereby forming the joining layers. In this way, the P-type thermoelectric conversion element 10 and the N-type thermoelectric conversion element 20 each is joined to the electrode 30 by the joining layers. For example, the thermoelectric conversion module of the present disclosure is manufactured in this way.

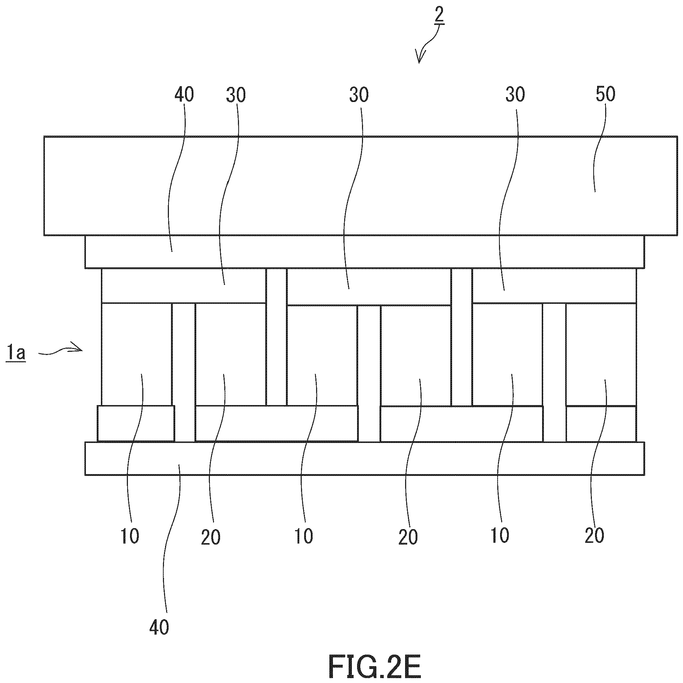

FIG. 2E is a schematic diagram showing an example of a thermoelectric conversion system of the present disclosure. As shown in FIG. 2E, the thermoelectric conversion system 2 includes a thermoelectric conversion module 1a and a heat source 50. In the thermoelectric conversion system 2, a temperature difference occurs by the heat source 50 on both sides of thermoelectric conversion module 1a, whereby electricity is generated in the thermoelectric conversion module 1a.

In the thermoelectric conversion system 2, the heat source 50 may include a heat transfer tube, and a predetermined heating medium is introduced into the heat transfer tube. The heating medium may be a gas such as exhaust gas, or a liquid such as water or oil. The heat source 50 may include a plate for collecting radiant heat.

As shown in FIG. 2E, for example, in the thermoelectric conversion system 2, one of the pair of substrates 40 is disposed between the heat source 50 and the electrodes 30. The thermoelectric conversion system 2 may include the thermoelectric conversion module 1b, 1c, or 1d.

EXAMPLES

Hereinafter, the present disclosure will be described in detail with reference to Examples, though the thermoelectric conversion material of the present disclosure is not limited to the specific embodiments shown below.

<Sample 1>

In a glove box of an argon atmosphere, granular Ge, granular In, granular Ti, granular Sb and granular Te were weighed. The weighing was carried out so that the mole ratio Ge:In:Sb:Te was 0.85:0.01:0.09:1. The thus weighed Ge, In, Sb and Te were introduced into a quartz tube. The quartz tube had an inner diameter of 8 mm and an outer diameter of 10 mm. Next, the interior of the quartz tube was brought into a vacuum state of $3 \times 10^{-2}$ Pa using a turbo molecular pump, and the quartz tube was sealed. This quartz tube was placed inside a table-top electric furnace F-1404P manufactured by Tokyo Garasu Kikai Co., Ltd., and the temperature inside the table-top electric furnace was maintained at 900°C for 12 hours. In this way, Ge, In, Sb, and Te inside the quartz tube were melted, whereby a melt was obtained. The quartz tube including the liquid-phase melt was then taken out from the table-top electric furnace, the quartz tube was placed in a water tank filled with sufficient water, thereby quenching the melt to obtain a solidified body. With the solidified body inside the quartz tube, the quartz tube was placed again inside the table-top electric furnace, and the temperature inside the table-top electric furnace was maintained at 600°C for 96 hours. In this way, a composition for a thermoelectric conversion material according to Sample 1 was obtained.

Next, the composition for a thermoelectric conversion material according to Sample 1 was pulverized on a mortar to obtain a powder according to Sample 1. The resulting powder was sintered by a spark plasma sintering (SPS) method to obtain a dense sintered body. The powder (2.0 g) was filled into a cylindrical die made of carbon. The die had an outer diameter of 50 mm and an inner diameter of 10 mm. The powder according to Sample 1 was sintered by SPS under conditions of applying a pressure of 60 MPa and heating with electricity for 10 minutes at 550°C. In this way, a thermoelectric conversion material according to Sample 1 was obtained. This thermoelectric conversion material was a P-type material with a constitution of $Ge_{0.85}In_{0.01}Sb_{0.09}Te$.

<Sample 2 to Sample 7>

Compositions for thermoelectric conversion materials according to Sample 2 to Sample 7 were prepared in the same manner as Sample 1 except that the addition amount of each raw material was adjusted so that the constitutions of the materials are as shown in Table 1. Thermoelectric conversion materials according to Sample 2 to Sample 7 were produced in the same manner as Sample 1 except that the respective compositions for thermoelectric conversion materials according to Sample 2 to Sample 7 were used. These thermoelectric conversion materials were P-type materials.

[Table 1]

| | Constitution of thermoelectric conversion material | Mole ratio (Ge+In+Ti+Mg+Sb)/Te |
|---|---|---|
| Sample 1 | $Ge_{0.85}In_{0.01}Sb_{0.09}Te$ | 0.95 |
| Sample 2 | $Ge_{0.84}Ti_{0.03}Sb_{0.09}Te$ | 0.96 |
| Sample 3 | $Ge_{0.84}In_{0.01}Ti_{0.02}Sb_{0.09}Te$ | 0.96 |
| Sample 4 | $Ge_{0.85}Mg_{0.05}Sb_{0.1}Te$ | 1 |
| Sample 5 | $Ge_{0.89}In_{0.01}Sb_{0.1}Te$ | 1 |
| Sample 6 | $Ge_{0.89}Ti_{0.03}Sb_{0.08}Te$ | 1 |
| Sample 7 | GeTe | 1 |

<Sample 8>

Granular Sb and granular Bi were melted at temperatures in a range from 1000°C to 1500°C using an arc melting method, whereby an alloy of Sb and Bi was obtained. Next, the obtained alloy was ground in a mortar to prepare a SbBi powder.

Next, powders of Mg and Te were added to the SbBi powder. Afterwards, these powders were thoroughly mixed. The mole ratio Mg:Sb:Bi:Te in the powder mixture was 3.2:1.5:0.49:0.01. The mixed powder was then fed to a tablet press to form a tablet. Next, the tablet was placed in a carbon crucible. The carbon crucible was filled with argon gas. The tablets were then heated for 10 seconds at a temperature in a range from 800°C to 1000°C. The tablet melted due to heating, whereby an ingot was obtained. Next, an ingot was introduced into a mortar placed in a glove box filled with argon gas. The ingot was ground in the mortar to obtain MgSbBiTe powder. The obtained powder had a particle size of 100 μm or less.

Next, the MgSbBiTe powder was sintered using the SPS method to obtain a sintered body. Sintering using SPS was performed as follows. First, MgSbBiTe powder was filled into a cylindrical graphite die. The die had an outer diameter of 50 mm and an inner diameter of 10 mm. This filling was carried out in a glove box filled with argon gas. Next, the die was placed in the chamber of the spark plasma sintering equipment. The chamber was adjusted in advance to an argon atmosphere. Next, while a pressure of 50 MPa was applied to the powder filled in the die, a pulsed current was applied to the die by a sintering device. By applying the current, the temperature of the die increased at a rate of approximately 50°C/min. After the die temperature reached the sintering temperature of 850°C, the die temperature was maintained at 850°C for 5 minutes. Heating of the die was then discontinued by stopping the current. After the temperature of the die lowered to room temperature, the cylindrical sintered body was removed from the die, and the thermoelectric conversion material of Sample 8 was obtained. This thermoelectric conversion material was N-type with a constitution of $Mg_{3.22}Sb_{1..52}Bi_{0.47}Te_{0.01}$.

[Crystal structure analysis]

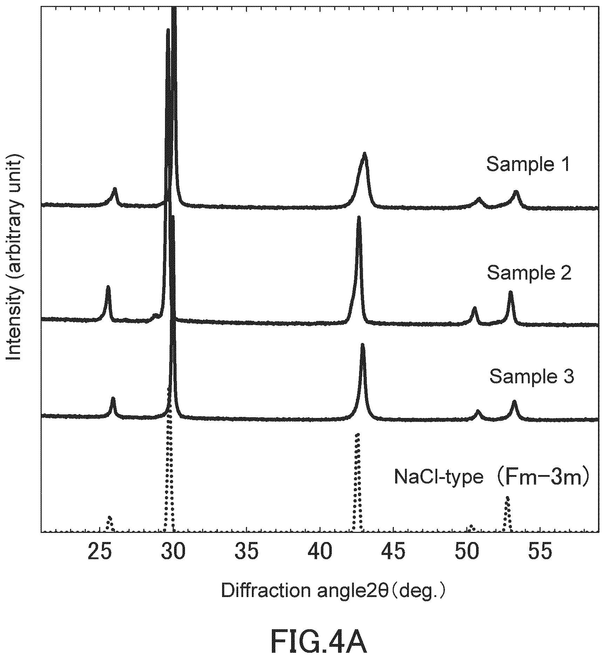

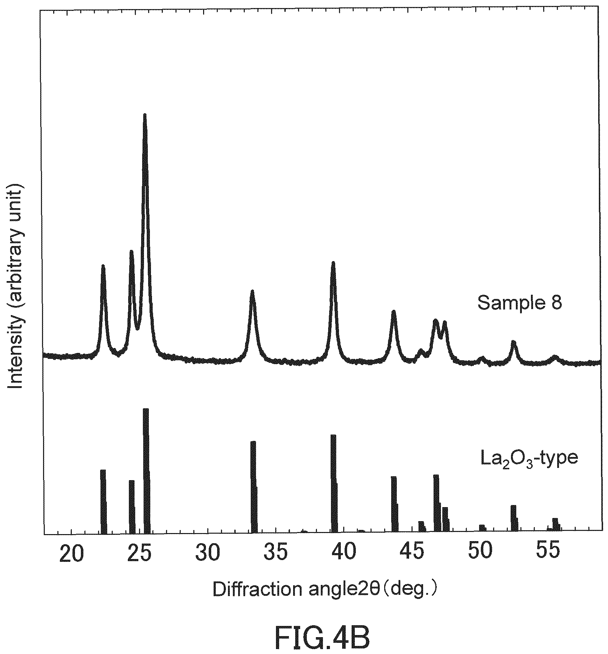

An X-ray diffraction measurement was performed on specimens produced from the thermoelectric conversion materials according to Samples 1-3 and 8, using an X-ray diffractometer Aeris manufactured by Malvern Panalytical. In this measurement, a Cu-Kα ray was used for the X-ray. FIG. 4A is a graph showing the X-ray diffraction measurement results for the thermoelectric conversion materials according to Samples 1 to 3. FIG. 4B is a graph showing the results of X-ray diffraction measurement of thermoelectric conversion material according to Sample 8. According to this measurement result, the thermoelectric conversion materials according to Samples 1 to 3 had a NaCl-type crystal structure, while the thermoelectric conversion material according to Sample 8 had a $La_2O_3$-type crystal structure.

[Thermal expansion coefficient]

Rectangular parallelepiped specimens for a thermomechanical analysis (TMA) were prepared from the thermoelectric conversion materials according to Samples 1, 3, 7, and 8. The lengths of the three mutually orthogonal sides of each specimen were about 8 mm, about 2 mm, and about 2 mm. The specimen was placed on a thermomechanical analyzer Thermo plus EVO2 TMA8311 manufactured by the Rigaku Corporation. To prevent deterioration of the specimen due to oxidation, the atmosphere inside the analyzer was replaced with argon at 0.5 atm. The thermal expansion coefficient (linear expansion coefficient) $dL/L_0$ was measured in a direction parallel to a side of about 8 mm in a temperature range of 30°C to 500°C with a compressive load of 100 mN applied while sweeping the temperature inside the device at a rate of 10°C/min.

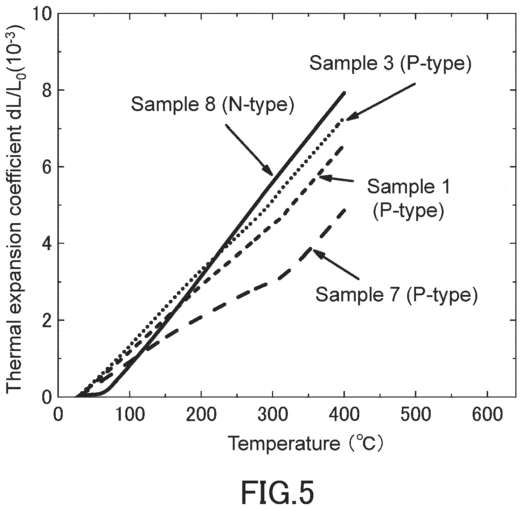

FIG. 5 is a graph showing the relationship between temperature and the thermal expansion coefficients $dL/L_0$ of the thermoelectric conversion materials according to Samples 1, 3, 7, and 8. As shown in FIG. 5, for example, $|(Xn - Xp)/Xn|$ at 400°C exceeds 0.3 in a comparison between Sample 7 and Sample 8. Xn indicates a thermal expansion coefficient of the N-type thermoelectric conversion material at a specific temperature in the temperature range from 30°C to 400°C, and Xp is the thermal expansion coefficient of the P-type thermoelectric conversion material at the specific temperature. It is thought that in the thermoelectric conversion material according to Sample 7, a structural phase transition from a rhombohedral phase to a cubic phase occurs at around 300°C, whereby the linearity of the thermal expansion coefficient collapses. It is estimated that for this reason, $|(Xn-Xp)/Xn|$ at 400°C exceeded 0.3 in Sample 7 and Sample 8.

On the other hand, in Samples 1 and 3, the linearity of the thermal expansion coefficient is maintained in the temperature range from 30°C to 400°C. According to the comparison of Samples 1, 3 with Sample 8, $|(Xn - Xp)/Xn|$ was 0.14 or less in the temperature range from 30°C to 400°C, that is, the difference between the thermal expansion coefficient of the P-type thermoelectric conversion material and the thermal expansion coefficient of the N-type thermoelectric conversion material is small.

[Breaking stress]

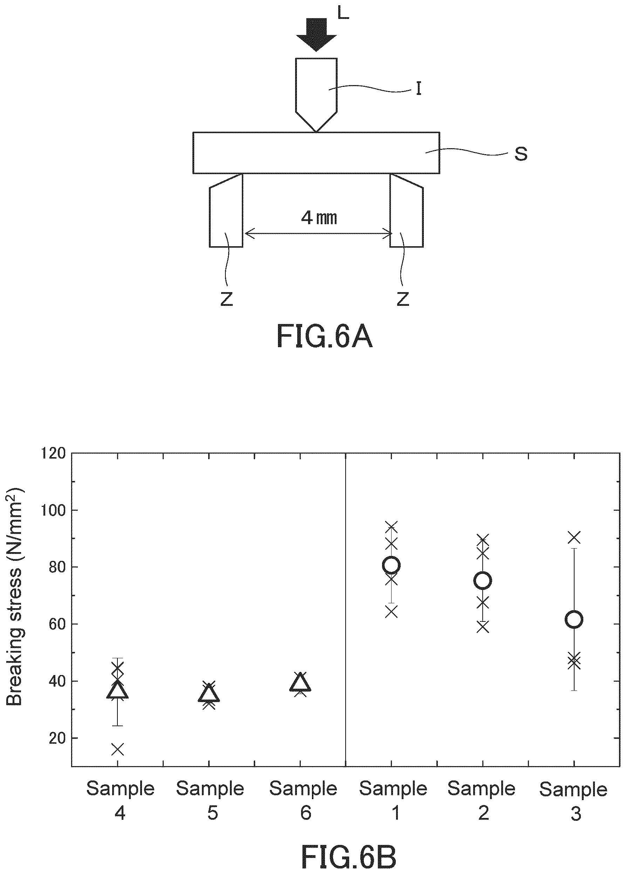

Test pieces S for the three-point bending test were prepared by cutting the thermoelectric conversion materials according to Samples 1 to 6. Each test piece S was a rectangular parallelepiped with a length of 4 mm or more, a thickness of about 2 mm, and a width of about 2 mm. FIG. 6A schematically shows a three-point bending test. As shown in FIG. 6A, a test piece S was disposed on a pair of jigs Z with the distance between the fulcrums adjusted to 4 mm, an indenter I was pressed against the test piece S to apply a load L, whereby a three-point bending test was performed in an environment of 25°C. In the three-point bending test, a tester EZ-Test manufactured by Shimadzu Corporation was used, and the test speed was set at 0.5 mm/min. In the three-point bending test, the maximum load [N] recorded just before fracture of the test piece S was considered as the breaking load, and the breaking stress $[N/mm^2]$ was calculated by dividing this breaking load by the area of the fracture surface of the test piece. The three-point bending test was conducted using two or more test pieces S for the thermoelectric conversion material according to each Example and each Comparative Example.

FIG. 6B is a graph showing the breaking stress of thermoelectric conversion materials according to Samples 1 to 6. The plots in FIG. 6B show the averages of the breaking stress of the thermoelectric conversion materials according to Samples 1 to 6. As shown in FIG. 6B, the averages of the breaking stress of the thermoelectric conversion materials according to Samples 4 to 6 were less than $40 N/mm^2$. In contrast, the averages of the breaking stress of the thermoelectric conversion materials according to Samples 4 to 6 were less than $40 N/mm^2$. The averages of the breaking stress of the thermoelectric conversion materials according to Samples 1 to 3 were more than $60 N/mm^2$. The breaking stress is likely to increase when at least one selected from the group consisting of In and Ti is included together with Ge, Te, and Sb, and when a molar ratio of a sum of contents of Ge, In, Ti, and Sb to a content of Te is less than 1.00.

[Thermoelectric conversion performance]

Specimens for thermoelectric property evaluation were prepared from the thermoelectric conversion materials according to Samples 1 to 3 and 8. The specimens each had a rectangular parallelepiped shape, and the lengths of the three mutually orthogonal sides were 6 mm or more, about 2 mm, and about 2 mm. Both end faces in the longitudinal direction of the specimen were polished using #8000 abrasive paper. This specimen was placed inside the thermoelectric property evaluation device ZEM-3 manufactured by Advance Science and Engineering. The interior of the device was adjusted to a helium atmosphere of 0.5 atm or 1 atm. The temperature inside the device was swept from room temperature to 500°C, and the Seebeck coefficient S and the electric conductivity $\sigma$ were measured at 50°C intervals. The electromotive force was measured at the time of adjusting the temperature difference between the upper block and lower block to 20°C, 30°C, and 40°C at the base temperature, whereby a regression line was determined for the plots showing the relationship between the electromotive force and the temperature difference between the upper and lower blocks. The Seebeck coefficient S at the base temperature was determined from the slope of this regression curve.

Specimens for heat conductivity measurements were prepared from the thermoelectric conversion materials according to Samples 1 to 3 and 8. The specimens each was disk-shaped with a thickness of about 1 mm and a diameter of about 10 mm. A carbon coating was formed on the surface of the specimen using a carbon spray. This specimen was placed inside a table-top laser flash analyzer LFA 457 MicroFlash manufactured by NETZSCH-Gerätebau. While flowing argon through the device at a flow rate of 300 mL/min, the temperature inside the device was swept from room temperature to 500°C, and the heat conductivity $\kappa$ of the sample was measured at 50°C intervals.

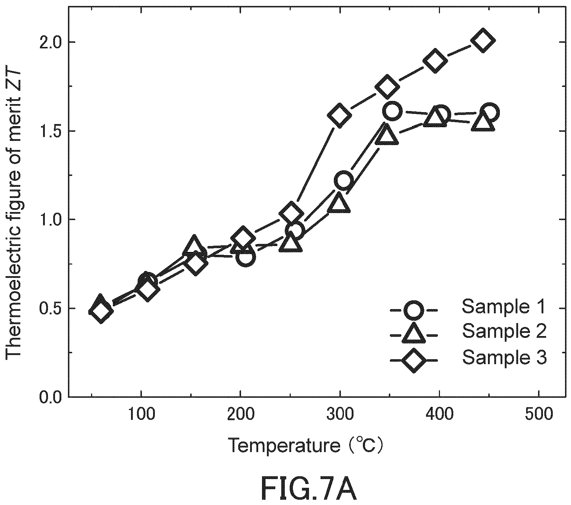

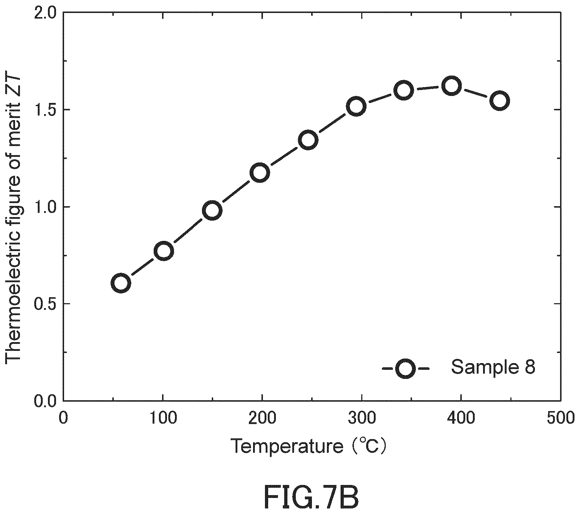

Based on the thus determined Seebeck coefficient S, electric conductivity $\sigma$, and heat conductivity $\kappa$, the dimensionless figure of merit ZT of the thermoelectric conversion materials according to Samples 1 to 3 and 8 were determined. FIG. 7A is a graph showing the relationship between temperature and the dimensionless figure of merit ZT of the thermoelectric conversion materials according to Samples 1 to 3. FIG. 7B is a graph showing the relationship between temperature and the dimensionless figure of merit ZT of the thermoelectric conversion materials according to Sample 8.

[Prediction of thermoelectric conversion module performance]

Based on the results regarding the thermoelectric conversion properties of the aforementioned thermoelectric conversion materials, a prediction was made about the maximum thermoelectric conversion efficiency of the thermoelectric conversion module prepared as a combination of a P-type thermoelectric conversion material according to Sample 3 and an N-type thermoelectric conversion material having a constitution of $Mg_{3.2}Sb_{1.5}Bi_{0.49}Te_{0.01}$. This prediction was made using the following procedure with reference to the description in Non Patent Literature 7.

The hot side temperature and the cold side temperature of the thermoelectric conversion element of the thermoelectric conversion module are expressed as $T_h$ and $T_c$, respectively. At this time, the temperature section from temperature $T_h$ to temperature $T_c$ is divided into N parts, and the temperature at each point is set as $T_n$. Here, n takes an integer value of 0 or more and N or less. The relationship $T_0 = T_h$ and $T_N = T_c$ holds true. The current density at each point of the thermoelectric conversion element is expressed as J. The Seebeck coefficient, the thermal conductivity, and the electrical resistivity of the thermoelectric conversion material corresponding to the temperature $T_n$ are expressed as $\alpha_n$, $\kappa_n$, and $\rho_n$, respectively. The relative current density $u_n$ at each point in the thermoelectric conversion element is expressed by the following Equation (1).

$$u_n = J/\kappa_n \nabla T_n \quad \text{Equation (1)}$$

The relative current density $u_n$ is expressed by the recurrence formula in Equation (2) below. In Equation (2), a relationship $\Delta T = T_n - T_{n-1}$ holds true. $\rho$, $\kappa$, and T each is the average in the interval from $T_{n-1}$ to $T_n$.

$$1/u_n = 1/u_{n-1}(1 - 2u^2_{n-1}\rho\kappa\Delta T)^{1/2} - T \times (\alpha_n - \alpha_{n-1}) \quad \text{Equation (2)}$$

By using the recurrence formula in Equation (2), the value of $u_n$ at n = 1, ... ,N can be obtained for both the P-type thermoelectric conversion element and the N-type thermoelectric conversion element, with $u_0$ as a variable. The thermoelectric conversion efficiency $\eta$ of a $\pi$-type structure thermoelectric conversion module prepared by combining a P-type thermoelectric conversion element and an N-type thermoelectric conversion element is expressed as a ratio $P/Q_h$ of the power generation amount P to the passing heat flow rate $Q_h$ on the high temperature side of the thermoelectric conversion element. Therefore, a thermoelectric conversion efficiency $\eta$ can be expressed as shown in Equation (3) below, using the above variables. The subscripts p and n in Equation (3) indicate values related to P-type thermoelectric conversion element and N-type thermoelectric conversion element, respectively.

$$\eta = 1 - (\alpha_{p,c}T_c + 1/u_{p,c} - \alpha_{n,c}T_c - 1/u_{n,c})/(\alpha_{p,h}T_h + 1/u_{p,h} - \alpha_{n,h}T_h - 1/u_{n,h}) \quad \text{Equation (3)}$$

The thermoelectric conversion efficiency $\eta$ is a function of $u_0$, and the maximum conversion efficiency $\eta_{max}$ can be determined as the maximum value of $\eta$ obtained when $u_0$ is varied. In other words, the temperature dependence of the maximum conversion efficiency $\eta_{max}$ can be predicted by deriving the optimal $u_0$ value in accordance with the requirement of the temperature difference $\Delta T = T_h - T_c$ given to the thermoelectric conversion module with a $\pi$-type structure. Furthermore, the optimal value of the ratio $A_p/A_n$ of the cross-sectional area $A_p$ of the P-type thermoelectric conversion element to the cross-sectional area $A_n$ of the N-type thermoelectric conversion element can be determined based on the following Equation (4). With the optimal value, the thermoelectric conversion efficiency may be maximized.

[Mathematical formula 1]

$$A_p/A_n = \int_{T_c}^{T_h} u_n \kappa_n \, dT \Big/ \int_{T_c}^{T_h} u_p \kappa_p \, dT \qquad \text{Equation (4)}$$

Based on Equations (1) to (4), a prediction was made for a maximum thermoelectric conversion efficiency of a thermoelectric conversion module with a $\pi$-type structure, where the thermoelectric conversion module was prepared by combining a P-type thermoelectric conversion material according to Sample 3 and an N-type thermoelectric conversion material having a constitution of $Mg_{3.2}Sb_{1.5}Bi_{0.49}Te_{0.01}$. In this prediction, the above evaluation results of thermoelectric conversion performance were referred to as the values of the Seebeck coefficient, the electrical resistivity, and the thermal conductivity of the P-type thermoelectric conversion material according to Sample 3. In addition, the description in Non Patent Literature 8 was referred to for the values of the Seebeck coefficient, the electrical resistivity, and the thermal conductivity of an N-type thermoelectric conversion material having a constitution of $Mg_{3.2}Sb_{1.5}Bi_{0.49}Te_{0.01}$. And the temperature on the low-temperature side of the thermoelectric conversion element was set at 27°C.

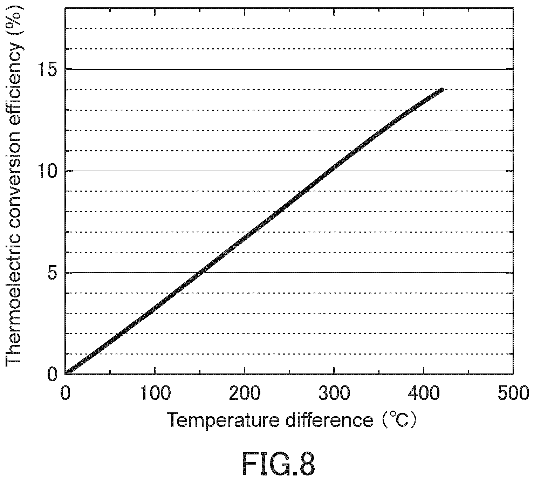

FIG. 8 is a graph showing an example of the predicted thermoelectric conversion efficiency of a thermoelectric conversion module based on the aforementioned prediction. In FIG. 8, the vertical axis indicates the thermoelectric conversion efficiency $\eta$, and the horizontal axis indicates the temperature difference $\Delta T$ given to the thermoelectric conversion module with a $\pi$-type structure. In FIG. 8, it was predicted that a high thermoelectric conversion efficiency of 14% would be achieved under the condition of $\Delta T = 420$°C. The value of the ratio $A_p/A_n$ for this case was 0.78. The optimal value of the ratio $A_p/A_n$ can be changed by, for example, adjusting the content of Te in the N-type thermoelectric conversion material, and adjusting the contents of Ge, In, Ti, Sb, and Bi in the P-type thermoelectric conversion element. Therefore, the optimal value of the ratio $A_p/A_n$ can be a value other than 0.78.

As described in Non Patent Literature 9, the thermoelectric conversion efficiency of a thermoelectric conversion module in which the P-type thermoelectric conversion element and the N-type thermoelectric conversion element each is made of a single material is 8% under the condition of $\Delta T = 565$ K. In this thermoelectric conversion module, an N-type PdS-based thermoelectric conversion material and a P-type PbTe-based thermoelectric conversion material are used. In addition, according to Non Patent Literature 9, a thermoelectric conversion module having a P-type thermoelectric conversion element and an N-type thermoelectric conversion element each formed of a plurality of materials has a thermoelectric conversion efficiency of 11.2% under the condition of $\Delta T = 585$ K. This thermoelectric conversion module uses an N-type PdS-based thermoelectric conversion material, a P-type PbTe-based thermoelectric conversion material, an N-type $Bi_2Te_3$-based thermoelectric conversion material, and a P-type $Bi_2Te_3$-based thermoelectric conversion material.

In the thermoelectric conversion module according to the present disclosure, toxic Pb is not used and a single thermoelectric conversion material can be used for each of the P-type thermoelectric conversion element and the N-type thermoelectric conversion element, whereby the manufacturing process can be simplified easily. In addition, the thermoelectric conversion module according to the present disclosure is capable of exhibiting high thermoelectric conversion efficiency.

INDUSTRIAL APPLICABILITY

A thermoelectric conversion module of the present disclosure can be used in a variety of applications, including the applications of conventional thermoelectric conversion modules.

**Claims**

**1.** A thermoelectric conversion module comprising:

an N-type thermoelectric conversion element;
a P-type thermoelectric conversion element; and
an electrode electrically connecting the P-type thermoelectric conversion element and the N-type thermoelectric conversion element,
wherein the N-type thermoelectric conversion element comprises an N-type thermoelectric conversion material,
the P-type thermoelectric conversion element comprises a P-type thermoelectric conversion material,
the N-type thermoelectric conversion material comprises Mg, and at least one selected from the group consisting of Sb and Bi,
the P-type thermoelectric conversion material comprises Ge, at least one selected from the group consisting of In and Ti, at least one selected from the group consisting of Sb and Bi, and Te,

the P-type thermoelectric conversion material satisfies a requirement (1): $\alpha + \beta + \gamma < 1.00$,

where $\alpha$ is a molar ratio of a content of Ge to a content of Te,

$\beta$ is a molar ratio of a sum of a content of In and a content of Ti to the content of Te, and
$\gamma$ is a molar ratio of a sum of a content of Sb and a content of Bi to the content of Te.

2. The thermoelectric conversion module according to claim 1, wherein
the N-type thermoelectric conversion material and the P-type thermoelectric conversion material satisfy a requirement (2): $|(Xn - Xp)/Xn| \leq 0.3$,
where Xn indicates a thermal expansion coefficient of the N-type thermoelectric conversion material at a specific temperature in a temperature range from 30°C to 400°C, and
Xp indicates a thermal expansion coefficient of the P-type thermoelectric conversion material at the specific temperature.

3. The thermoelectric conversion module according to claim 1 or 2, wherein the P-type thermoelectric conversion material satisfies a requirement (3): $\beta + \gamma < \alpha$.

4. The thermoelectric conversion module according to any one of claims 1 to 3, wherein the P-type thermoelectric conversion material satisfies a requirement (4): $\alpha + \beta + \gamma \geq 0.85$.

5. The thermoelectric conversion module according to any one of claims 1 to 4, wherein the P-type thermoelectric conversion material has a first constitution representing $Ge_{\alpha}In_xTi_{\beta-x}Sb_yBi_{\gamma-y}Te$, where requirements $0 \leq x \leq \beta$ and $0 \leq y \leq \gamma$ are satisfied.

6. The thermoelectric conversion module according to any one of claims 1 to 5, wherein the N-type thermoelectric conversion material comprises a $Mg_3(Sb,Bi)_2$-based N-type thermoelectric conversion material.

7. The thermoelectric conversion module according to any one of claims 1 to 6, wherein

the N-type thermoelectric conversion material has a second constitution representing $Mg_{3+m-a-b}A_aB_bC_{2-c-e}D_cE_e$,

wherein

A is at least one element selected from the group consisting of Ca, Sr, Ba, Nb, Zn, and Al,
B is at least one element selected from the group consisting of Sc, Y, La, and Ce,
C is at least one element selected from the group consisting of Sb and Bi,
D is at least one element selected from the group consisting of Mn, Si, and Cr,
E is at least one element selected from the group consisting of Se and Te, and
requirements $-0.1 \leq m \leq 0.4$, $0 \leq a \leq 0.1$, $0 \leq b \leq 0.04$, $0 \leq c \leq 0.1$, and $0.001 \leq e \leq 0.06$ are satisfied.

8. The thermoelectric conversion module according to any one of claims 1 to 7, wherein
the P-type thermoelectric conversion element comprises: a P-type thermoelectric conversion body comprising the P-type thermoelectric conversion material; and a first layer disposed between the P-type thermoelectric conversion body and the electrode, wherein the first layer comprises: at least one metal selected from the group consisting of Fe, Cu, Ti, Mo, W, and Ni; an alloy comprising Sn and Te; or an alloy comprising Al and Si.

9. The thermoelectric conversion module according to any one of claims 1 to 8, wherein

the N-type thermoelectric conversion element comprises: an N-type thermoelectric conversion body comprising the N-type thermoelectric conversion material; and a second layer disposed between the N-type thermoelectric conversion body and the electrode, wherein
the second layer comprises Cu or Fe.

10. A thermoelectric conversion system comprising:

the thermoelectric conversion module according to any one of claims 1 to 9; and
a heat source.

FIG.1

FIG.2A

1b

30 (31)

10

20

30 (32)

40

30 (33)

FIG.2B

<u>1c</u>

30 (31)

10

20

30 (32)

30 (33)

# FIG.2C

1d

30 (31)

12
11

10 { 10a

11
12

30 (32)

22
21

20a } 20

21
22

30 (33)

## FIG.2D

FIG.2E

FIG.3A

FIG.3B

FIG.4A

FIG.4B

FIG.5

FIG.6A

FIG.6B

FIG.7A

FIG.7B

FIG.8

## INTERNATIONAL SEARCH REPORT

| International application No. |
|---|
| **PCT/JP2022/047479** |

### A. CLASSIFICATION OF SUBJECT MATTER

*H10N 10/852*(2023.01)i; *C22C 23/00*(2006.01)i; *C22C 28/00*(2006.01)i; *H10N 10/01*(2023.01)i; *H10N 10/853*(2023.01)i
FI: H10N10/852; H10N10/853; H10N10/01; C22C23/00; C22C28/00 B

According to International Patent Classification (IPC) or to both national classification and IPC

### B. FIELDS SEARCHED

Minimum documentation searched (classification system followed by classification symbols)

H10N10/852; C22C23/00; C22C28/00; H10N10/01; H10N10/853

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

Science Direct; IEEE Xplore; Wiley Online Library; ACS PUBLICATIONS

### C. DOCUMENTS CONSIDERED TO BE RELEVANT

| Category* | Citation of document, with indication, where appropriate, of the relevant passages | Relevant to claim No. |
|---|---|---|
| Y | JP 2019-207983 A (PANASONIC IP MANAGEMENT CORPORATION) 05 December 2019 (2019-12-05)<br>    paragraphs [0001]-[0020], [0052]-[0055], fig. 2, 3 | 1, 3-10 |
| Y | 小菅厚子, 石橋広記, 久保田佳基, 木舩弘一, ホモロガス構造を有するGe-Sb-Te系化合物の結晶構造と熱電特性, 日本金属学会誌, 2015, vol. 79, no. 11, <DOI:10.2320/jinstmet.JA201506>, pp. 562-568, (KOSUGA, Atsuko, ISHIBASHI, Hiroki, KUBOTA, Yoshiki, KIFUNE, Kouichi. Crystal Structure and Thermoelectric Properties of Ge-Sb-Te Homologous Structure. Journal of the Japan Institute of Metals and Materials.)<br>    particularly, abstract, pp. 565-567 | 1, 6-10 |
| Y | WU, Di et al. High Thermoelectric Performance Achieved in GeTe-Bi2Te3 Pseudo-Binary via Van der Waals Gap-Induced Hierarchical Ferroelectric Domain Structure. Advanced Functional Materials. 2019, vol. 29, <DOI:10.1002/adfm.201806613>, 1806613<br>    particularly, 2. Results and discussions | 1, 3-6, 8-10 |

☑ Further documents are listed in the continuation of Box C.   ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **07 February 2023** | **21 February 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| International application No. |
| --- |
| **PCT/JP2022/047479** |

**C.    DOCUMENTS CONSIDERED TO BE RELEVANT**

| Category* | Citation of document, with indication, where appropriate, of the relevant passages | Relevant to claim No. |
| --- | --- | --- |
| Y | SHUAI, Jing et al. Enhanced thermoelectric performance through crystal field engineering in transition metal doped GeTe. Materials Today Physics. 2019, vol. 9, <DOI:10.1016/ j.mtphys.2019.100094>, 100094<br>    particularly, pp. 1, 4-6 | 1, 3-6, 8-10 |
| Y | JP 2020-167265 A (NATIONAL INSTITUTE OF ADVANCED INDUSTRIAL SCIENCE AND TECHNOLOGY) 08 October 2020 (2020-10-08)<br>    paragraphs [0006], [0017]-[0019], fig. 2 | 7-10 |
| Y | JP 2014-195080 A (FURUKAWA COMPANY, LIMITED) 09 October 2014 (2014-10-09)<br>    paragraphs [0038]-[0050], fig. 1 | 8-10 |
| Y | JP 2014-086623 A (FURUKAWA COMPANY, LIMITED) 12 May 2014 (2014-05-12)<br>    paragraphs [0017]-[0033], [0046]-[0051], fig. 1, 2 | 8-10 |
| Y | JP 2021-168336 A (HITACHI, LIMITED) 21 October 2021 (2021-10-21)<br>    paragraph [0023], fig. 5 | 10 |
| A | CN 113121234 A (INSTITUTE OF ELECTRICAL ENGINEERING, CHINESE ACADEMY OF SCIENCES) 16 July 2021 (2021-07-16)<br>    paragraph [0020] | 2 |

Form PCT/ISA/210 (second sheet) (January 2015)

INTERNATIONAL SEARCH REPORT
Information on patent family members

International application No.

**PCT/JP2022/047479**

| Patent document cited in search report | | | Publication date (day/month/year) | Patent family member(s) | Publication date (day/month/year) |
|---|---|---|---|---|---|
| JP | 2019-207983 | A | 05 December 2019 | (Family: none) | |
| JP | 2020-167265 | A | 08 October 2020 | (Family: none) | |
| JP | 2014-195080 | A | 09 October 2014 | US 2010/0294326 A1 paragraphs [0087]-[0099], fig. 1 | |
| JP | 2014-086623 | A | 12 May 2014 | (Family: none) | |
| JP | 2021-168336 | A | 21 October 2021 | (Family: none) | |
| CN | 113121234 | A | 16 July 2021 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6127281 B

- WO 2020003554 A1

**Non-patent literature cited in the description**

- **W. LIU et al.** High-Performance GeTe-Based Thermoelectrics: from Materials to Devices. *Adv. Energy Mater.*, 2020, vol. 20, 2000367
- **T. XING et al.** Superior performance and high service stability for GeTe-based thermoelectric compounds. *Natl. Sci. Rev.*, 2019, vol. 6, 944-954
- **M. HONG et al.** Realizing zT of 2.3 in Ge1-x-ySbxInyTe via Reducing the Phase-Transition Temperature and Introducing Resonant Energy Doping. *Advanced Materials*, 2018, vol. 30 (1705942)
- **M. LI et al.** Crystal symmetry induced structure and bonding manipulation boosting thermoelectric performance of GeTe. *Nano Energy*, 2020, vol. 73 (104740)
- **G. BAI et al.** Boron Strengthened GeTe-Based Alloys for Robust Thermoelectric Devices with High Output Power Density. *Adv. Energy Mater.*, 2021, vol. 11, 2102012

- **M. HONG et al.** Computer-aided design of high-efficiency GeTe-based thermoelectric devices. *Energy Environ. Sci.*, vol. 13, 1856-1864
- Thermoelectric Power Generation: Efficiency and Compatibility. **G. J. SNYDER**. Thermoelectrics Handbook: Macro to Nano. CRC Press, 2006
- **T. KANNO et al.** Enhancement of average thermoelectric figure of merit by increasing the grain-size of Mg3.2Sb1.5Bi0.49Te0.01. *Energy Environ. Sci.*, 2020, vol. 13, 579-591
- **B. JIANG et al.** Realizing high-efficiency power generation in low-cost PbS-based thermoelectric materials. *Energy Environ. Sci.*, 2020, vol. 13, 579-591